# EUROPEAN PATENT APPLICATION

(11) **EP 3 517 786 A1**
(43) Date of publication of application: **31.07.2019**
(21) Application number: 18195655.8
(22) Date of filing: 20.09.2018
(51) Int. Cl.: F04D 25/14

(54) **LOUVER INTEGRATED DESIGN FOR FAN MODULE**

(30) Priority: 30.01.2018 US 201862623714 P; 07.05.2018 US 201815972795
(71) Applicant: Quanta Computer Inc., Taoyuan City 333 (TW)
(72) Inventor: CHEN, Chao-Jung, 333 Taoyuan City (TW); HUANG, Yu-Nien, 333 Taoyuan City (TW); WU, Kuen-Hsien, 333 Taoyuan City (TW)
(74) Representative: Winter, Brandl, Fürniss, Hübner, Röss, Kaiser, Polte - Partnerschaft mbB

(57) **Abstract**

A fan assembly is disclosed to prevent reverse air flow when the fan stops working. The assembly has a fan module including an intake end, a motor casing and a motor propelling a fan. A louver module has a plurality of slats having an open position to allow air flow and a closed position to block air flow. The louver module is coupled to the motor casing to provide a seal between the louver module and the motor casing.

## Description

### TECHNICAL FIELD

The present disclosure relates generally to a fan system. More particularly, aspects of this disclosure relate to an integrated fan module that incorporates a louver to prevent reverse fan flow.

### BACKGROUND

Electronic devices, such as servers, include numerous electronic components that are powered to a common power supply. Servers generate an enormous amount of heat due to the operation of internal electronic devices such as controllers, processors, and memory. Overheating from the inefficient removal of such heat has the potential to shut down or impede the operation of such devices. Thus, servers are designed to rely on air flow through the interior of the device to carry away heat generated from electronic components. Servers often include various heat sinks that are attached to the electronic components such as processing units. Heat sinks are typically composed of thermally conductive material. Heat sinks absorb the heat from the electronic components, thus transferring the heat away from the components. The heat from heat sinks must be vented away from the server. Air flow to vent away such heat is often generated by a fan system. The generated air flow thus carries collected heat away from the components and the heat sink. A good thermal design can assure the smallest fan power with limited air flow is sufficient to cool a fixed server or switch system power level. Thus, air flow can pass through hot electric components in the device without any reverse air flow because the internal layout effectively channels the air flow.

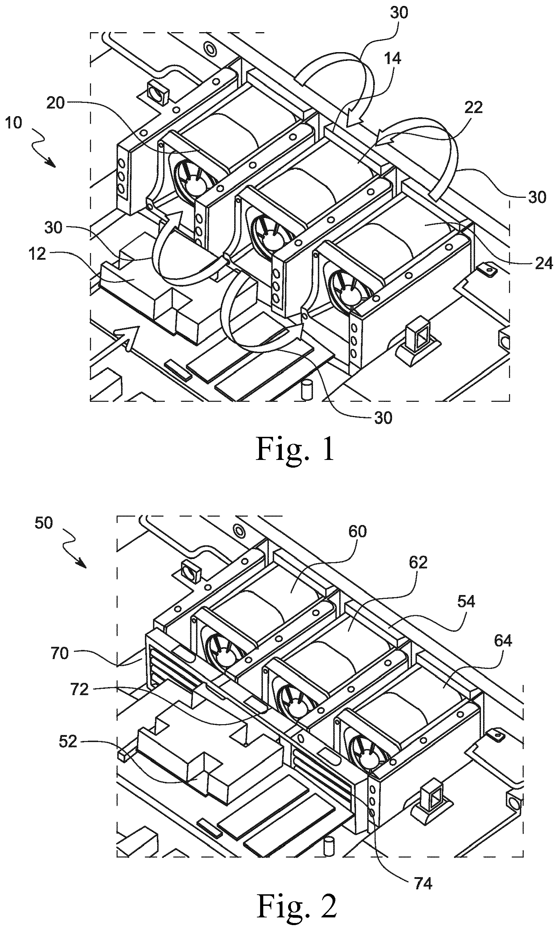

A typical fan system will include multiple fans. Such fans may be grouped together in a fan wall to provide maximum cooling. Further, additional fans provide redundancy that allows for the operation of the server even if one of the fans in the fan wall fails. However, one issue with grouping fans occurs when a single fan fails. Reverse air flow occurs because the failed fan creates a low pressure area. FIG. 1 is a perspective view of a server 10 that includes various components 12 that illustrates the reverse flow problem. The components 12 are cooled by a fan wall 14. The fan wall 14 in this example includes separate fans 20, 22, and 24. In this example, the fan 22 has failed and thus stops providing air flow. The lack of air flow from the fan 22 creates a low pressure area because the remaining fans 20 and 24 continue to create air flow. The reverse air flow is mainly from a fan outlet high pressure area backward to a fan inlet low pressure area around the non-functioning fan 22. The low pressure area creates reverse air flow as shown by arrows 30. The reverse air flow will reduce overall system air flow therefore cooling of components in the server 10 will be compromised.

In order to solve this reverse flow issue, a louver device has been installed in front of each fan module. FIG. 2 shows such a server 50 that includes various electronic components 52. The components 52 are cooled by a fan wall 54. The fan wall 54 includes separate fans 60, 62, and 64. Each of the fans 60, 62, and 64 have a corresponding front fan louver 70, 72, and 74. When a fan fails, impellers of the corresponding front fan louver will be closed and therefore block the reverse air flow. However, the front fan louver design needs a perfect air tunnel, without air leakage between the fan and the louver, in order to block all of the reverse air flow. Because there is a gap between the fan louvers 70, 72, and 74, and the intakes of the fans 60, 62, and 64, there is still reverse air flow when one of the fans fails. Thus, even with the addition of the louvers, current cooling systems still suffer from loss of cooling capability due to reverse air flow when a fan fails.

Thus, there is a need for a fan system that uses a louver to effectively prevent reverse air flow when a fan fails. There is also a need for a fan system that allows a louver frame to be easily mated to a fan module. There is a further need for an integrated fan system that blocks any leaking reverse air flow when a louver is activated.

### SUMMARY

One disclosed example is a fan assembly. The assembly has a fan module including an intake end, a motor casing, and a motor propelling a fan, and a vent end. A louver module has a plurality of slats having an open position to allow air flow, and a closed position to block air flow. The louver module is coupled to the motor casing to provide a seal between the louver module and the motor casing.

Another example is a fan louver module for connection with a motor casing of a fan. The fan louver module includes a frame having side walls and top and bottom walls. A plurality of slats is mounted in the frame. The plurality of slats have an open position to allow air flow though the frame, and a closed position to block air flow through the frame. The frame has approximately the same cross section area as the motor casing of the fan. The frame is attachable to the motor casing to provide a seal between the motor casing and the frame.

The above summary is not intended to represent each embodiment or every aspect of the present disclosure. Rather, the foregoing summary merely provides an example of some of the novel aspects and features set forth herein. The above features and advantages, and other features and advantages of the present disclosure, will be readily apparent from the following detailed description of representative embodiments and modes for carrying out the present invention, when taken in connection with the accompanying drawings and the appended claims.

### BRIEF DESCRIPTION OF THE DRAWINGS

The disclosure will be better understood from the following description of exemplary embodiments together with reference to the accompanying drawings, in which:
FIG. 1 is a prior art server having a series of fans showing the problem of reverse air flow;
FIG. 2 is another prior art server having a series of louvers in front of fans, that attempts to addresses the problem of reverse air flow;
FIG. 3 is a perspective back view of a fan module with an integrated louver;
FIG. 4 is a perspective front view of the fan module and louver structure in FIG. 3;
FIG. 5 is a perspective rear view of the integrated louver module in FIG. 3;
FIG. 6 is a perspective view of the louver module in FIG. 3 with the louver open; and
FIG. 7 is a perspective view of the louver module in FIG. 3 with the louver closed.

The present disclosure is susceptible to various modifications and alternative forms. Some representative embodiments have been shown by way of example in the drawings and will be described in detail herein. It should be understood, however, that the invention is not intended to be limited to the particular forms disclosed. Rather, the disclosure is to cover all modifications, equivalents, and alternatives falling within the spirit and scope of the invention as defined by the appended claims.

### DETAILED DESCRIPTION

The present inventions can be embodied in many different forms. Representative embodiments are shown in the drawings, and will herein be described in detail. The present disclosure is an example or illustration of the principles of the present disclosure, and is not intended to limit the broad aspects of the disclosure to the embodiments illustrated. To that extent, elements, and limitations that are disclosed, for example, in the Abstract, Summary, and Detailed Description sections, but not explicitly set forth in the claims, should not be incorporated into the claims, singly or collectively, by implication, inference, or otherwise. For purposes of the present detailed description, unless specifically disclaimed, the singular includes the plural and vice versa; and the word "including" means "including without limitation." Moreover, words of approximation, such as "about," "almost," "substantially," "approximately," and the like, can be used herein to mean "at," "near," or "nearly at," or "within 3-5% of," or "within acceptable manufacturing tolerances," or any logical combination thereof, for example.

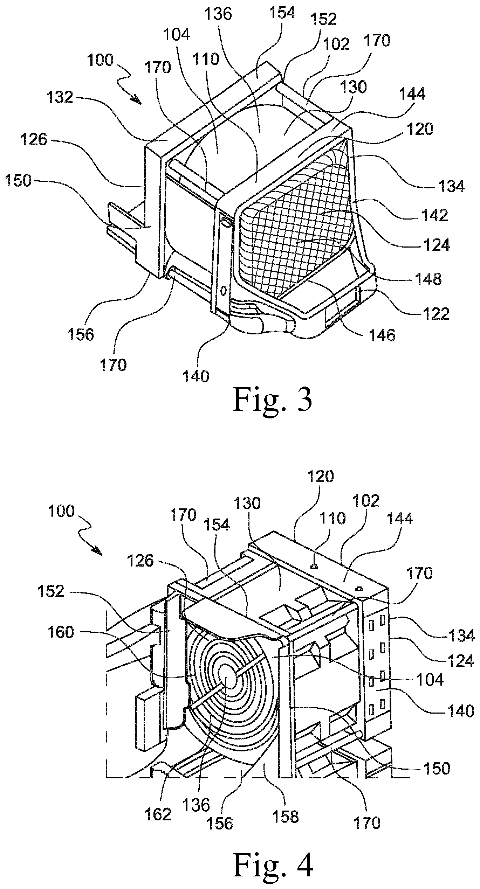

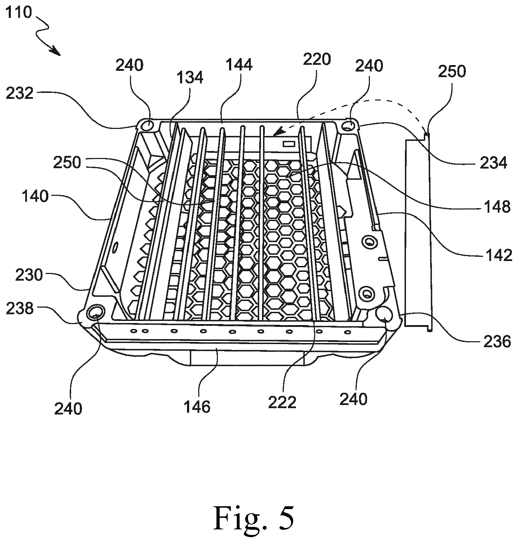

FIG. 3 shows a back perspective view of a fan assembly 100 having an integrated fan module 102 with an integrated louver module 110. FIG. 4 shows a front perspective view of the fan assembly 100. FIG. 5 is a perspective view of the louver module 110 separated from the fan module 102. Like elements are labeled with identical element numbers throughout FIGs. 3-5.

As shown in FIG. 3, the fan module 102 includes a carrier structure 120. The carrier structure 120 includes a handle 122 that allows the fan module 102 to be easily removed from an electronic device, such as a server or network switch. The carrier structure 120 includes a rear end 124 that vents air flow and an opposite front air intake end 126 that draws in air flow. The carrier structure 120 includes a motor casing 130, that is located between the intake end 126 and the rear end 124. The motor casing 130 holds a motor 136 and a fan 104. The fan has a series of fan blades that is propelled by the motor 136. The motor 136 is powered via cable connectors that may be attached to a power source, such as a power supply unit on a board of the electronic device. Power supply signals to the motor 136 cause the fan 104 to rotate. Fan 104 rotation draws air in from the intake end 126 and pushes air out through the rear end 124.

The carrier structure 120 includes a front frame 132 and a rear frame 134. The front frame 132 and the rear frame 134 are on opposite sides of the motor casing 130. The rear frame 134 includes side members 140 and 142. The side members 140 and 142 are attached to the handle 122. The side members 140 and 142 are joined by a top member 144, and a bottom member 146. The rear frame 134 includes a grill 148 that serves to prevent particles from entering the carrier structure 120. As will be explained below, the side members 140 and 142 and the top and bottom members 144 and 146 form the louver module 110.

As shown in FIG. 4, the front frame 132 includes side members 150 and 152. The side members 150 and 152 are joined by a top member 154 and a bottom member 156. The side members 150 and 152, the top member 154, and the bottom member 156, form a front surface 158 that defines an intake opening 160. The intake opening 160 includes a webbing pattern 162 that allows air flow to be directed toward the fan propelled by the motor in the motor casing 130. A series of rods 170 are employed to attach the front frame 132 to the rear frame 134 (in FIG. 3). The rods 170 span the length of the motor casing 130.

As shown in FIG. 5, the louver module 110 is integrated in the rear frame 134. The rear frame 134 is defined by the top member 144, the bottom member 146, and the side members 140 and 142. One side of rear frame 134 is closed by the grill 148 that is attached to one side of the side members 140 and 142, and the top and bottom members 144 and 146. The top member 144 and the bottom member 146 each have respective interior surfaces 220 and 222. The opposite side of the members 140, 142, 144, and 146 form a contact surface 230, that is defined by four corner supports 232, 234, 236, and 238 at the junctions of the side members 140 and 142, top member 144, and bottom member 146.

The members 140, 142, 144, and 146 define an opening that is roughly the same cross sectional area as the output area from the fan in the motor casing 130. When the rear frame 134 and integrated louver module 110 is attached to the motor casing 130 (as shown in FIGs. 3 and 4), the contact surface 230 of the members 140, 142, 144, and 146 are flush with the motor casing 130 and form a seal to prevent air flow from leaking out of the side of the fan assembly 100. The four corner supports 232, 234, 236, and 238, each may include a hole 240 that allows the rods 170 to be inserted and join the rear frame 134 with the front frame 132. The front frame 132 has similar holes to accommodate the rods 170. The holes 240 may have screw threads that allow the rods 170 be screwed into the holes and thus hold the front frame 132 in relation to the rear frame 134.

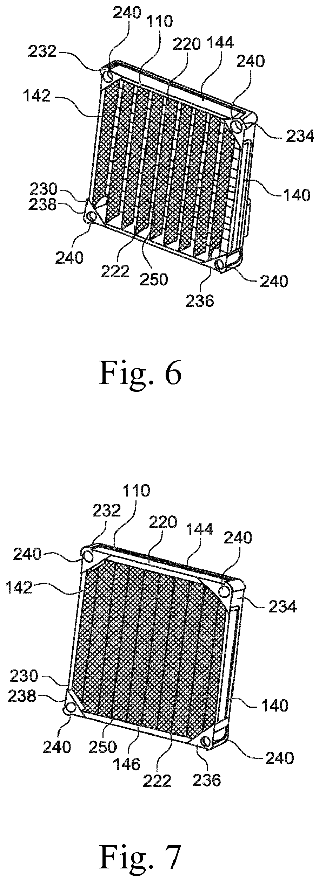

As show in FIGs. 6 and 7, a series of slats 250 are rotatably attached between the interior surfaces 220 and 222 of the top and bottom members 144 and 146. Each of the slats 250 are mounted similar to an impeller blade. The slats 250 may be rotated between an open position (as shown in FIG. 6) and a closed position (as shown in FIG. 7). The open position is where the slats 250 are parallel to the side members 140 and 142, thereby allowing air flow between the slats 250 (as shown in FIG. 5). The closed position is where the slats 250 are perpendicular to the side members 140 and 142, thereby blocking air flow through the fan assembly 100. When the fan assembly 100 is functioning, air flow is drawn from the front air intake end 126, through the motor casing 130, and through the louver module 110. The air flow forces the slats 250 into the open position. When the fan assembly 100 fails, reverse air flow causes air flow in the direction from the rear end 124 to the louver module 110. This reverse air flow causes the slats 250 to swing to the closed position and thereby prevents air flow through the rest of the fan module 102. In this example, the slats are vertically oriented, but it is to be understood that the principles herein may apply horizontally oriented slats that would be mounted between the side members 140 and 142.

The above example is based on the concept of a louver impeller assembled to lock onto an existing fan carrier structure 120. The impeller mechanism (slats 250 in FIGs. 6-7) is designed in either a vertical or horizontal direction, which can be blown open by the fan 104 driving air. Once fan 104 failure occurs, the pressure difference between the fan 104 inlet and outlet will force the impeller of the louver module 110 be closed automatically. The integrated nature of the louver module 110 in the fan assembly 100 prevents reverse air flow by eliminating any gaps between the louver 110 and the fan module 102. One benefit of present example fan system is to eliminate reverse air flow, which is blocked by the louver module 110. The elimination of reverse air flow thus allows maximum air flow through other fans. The principles above can eliminate the reverse air flow and simplify fan louver design. In a traditional design, a louver frame has slats inside and is a separate component. Such a louver must be located in front of a fan module to block reverse air flow. As explained above, a separate louver frame is no longer needed as the slats are integrated inside the carrier structure 120. The above described principles may there simplify the louver design as integrated with the fan itself.

Although the invention has been illustrated and described with respect to one or more implementations, equivalent alterations, and modifications will occur or be known to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. A integrated fan assembly (100), comprising:
a fan module (102) including an intake end (126), a motor casing (130), and a motor (136) propelling a fan (104); and
a louver module (110) having a plurality of slats (250) having an open position (Fig. 6) to allow air flow and a closed position (Fig. 7) to block air flow, wherein the louver module (110) is coupled to the motor casing (130) to provide a seal between the louver module (110) and the motor casing (130).

2. The assembly (100) of claim 1, wherein the louver module (110) includes a rear frame (134) having a handle (122).

3. The assembly (100) of claim 1, wherein the plurality of slats (250) is forced to the closed position (Fig. 7) when air flow occurs from the louver module (110) to the intake end (126).

4. The assembly (100) of claim 1, further comprising a front frame (132) coupled to the motor casing (130).

5. The assembly (100) of claim 1, further comprising a grill (148) attached to the louver module (110) for transmission of air flow.

6. The assembly (100) of claim 1, wherein the plurality of slats (250) is vertically oriented and rotatably attached to top (144, 154) and bottom members (146, 156) of the louver module (110).

7. The assembly (100) of claim 1, wherein the plurality of slats (250) is horizontally oriented and rotatably attached to side members (140, 142, 150, 152) of the louver module (110).

8. A fan louver module (110) for connection with a motor casing (130) of a fan (104), the fan louver module (110) comprising:
a frame (132, 134) having side walls (140, 142, 150, 152)and top (144, 154) and bottom walls (146, 156); and
a plurality of slats (250)mounted in the frame, the plurality of slats (250) having an open position (Fig. 6) to allow air flow though the frame (132, 134) and a closed position (Fig. 7) blocking air flow through the frame (132, 134);
wherein the frame (132, 134) has approximately the same cross section area as a front end of the motor casing (130), and wherein the frame (132, 134) is attachable to the motor casing (130) of the fan (104) to provide a seal between the motor casing (130) and the frame (132, 134).

9. The fan louver module (110) of claim 8, wherein the plurality of slats (250) is forced to the closed position (Fig. 7) when air flow occurs from the frame (132, 134) to the motor casing (130).

10. The fan louver module (110) of claim 8, wherein the frame (132, 134) of the louver module (110) includes a first attachment point that may be joined with a corresponding attachment point on a front frame (132) of the fan (104).

11. The fan louver module (110) of claim 8, wherein the plurality of slats (250) is vertically oriented and rotatably attached to top (144, 154) and bottom members (146, 156) of the frame (132, 134).

12. The fan louver module (110) of claim 8, wherein the plurality of slats (250) is horizontally oriented and rotatably attached to the side members (140, 142, 150, 152) of the frame (132, 134).
